**Europäisches Patentamt**

**European Patent Office**

**Office européen des brevets**

(11) Veröffentlichungsnummer: **0 075 086**
**A2**

## (12) EUROPÄISCHE PATENTANMELDUNG

(21) Anmeldenummer: **82106397.1**

(22) Anmeldetag: **16.07.82**

(51) Int. Cl.³: **H 03 K 17/945**

(30) Priorität: **22.09.81 DE 3137706**
**17.03.82 DE 3209673**

(43) Veröffentlichungstag der Anmeldung: **30.03.83**
**Patentblatt 83/13**

(84) Benannte Vertragsstaaten: **AT BE CH FR GB IT LI LU NL SE**

(71) Anmelder: **Buck, Robert, Am Kirchbühl 28,**
**D-7995 Neukirch (DE)**
Anmelder: **Marhofer, Gerd, Beckmannsbusch 67,**
**D-4300 Essen-Bredeney (DE)**

(72) Erfinder: **Buck, Robert, Am Kirchbühl 28,**
**D-7995 Neukirch (DE)**
Erfinder: **Marhofer, Gerd, Beckmannsbusch 67,**
**D-4300 Essen-Bredeney (DE)**
Erfinder: **Gesthuysen, Hans Dieter, Dipl.-Ing.,**
**Uhlandstrasse 3, D-4300 Essen-Kettwig (DE)**

(74) Vertreter: **Gesthuysen, Hans Dieter, Dipl.-Ing. et al,**
**Patentanwälte Gesthuysen + von Rohr**
**Huyssenallee 15 Postfach 10 13 33, D-4300 Essen 1 (DE)**

(54) Schaltungsanordnung mit einem Schaltgerät und einem Fehlerindikator.

(57) Dargestellt und beschrieben ist eine Schaltungsanordnung mit einem elektronischen, berührungslos arbeitenden Schaltgerät (1) und einem an den Ausgang (2) des Schaltgerätes (1) angeschlossenen Fehlerindikator (3). Das elektronische Schaltgerät (1) weist einen von außen beeinflußbaren Anwesenheitsindikator (4) und einen von dem Anwesenheitsindikator (4) steuerbaren elektronischen Schalter (5) auf. Mit Hilfe des Fehlerindikators (3) ist feststellbar, ob das elektronische Schaltgerät (1) und/oder ein an das elektronische Schaltgerät (1) angeschlossener Außenleiter (6, 7) einen Fehler aufweist.

Um sicherzustellen, daß der Fehlerindikator (3) dann und nur dann ein Fehlersignal abgibt, wenn das Schaltgerät (1) und/oder ein Außenleiter (6, 7) einen Fehler aufweist, ist bei dem Schaltgerät (1) zwischen den Anwesenheitsindikator (4) und dem Steuereingang (8) des elektronischen Schalters (5) ein exklusives ODER-Gatter (9) geschaltet, wobei der erste Eingang (10) des exklusiven ODER-Gatters (9) an den Ausgang (11) des Anwesenheitsindikators (4) und der Ausgang (12) des exklusiven ODER-Gatters (9) an den Steuereingang (8) des elektronischen Schalters (5) angeschlossen sind, ist an den zweiten Eingang (13) des exklusiven ODER-Gatters (9) ein Überwachungsimpulsgenerator (14) angeschlossen und gibt der Fehlerindikator (3) dann ein Fehlersignal ab, wenn am Fehlerindikator (3) keine ununterbrochene Folge von Überwachungsimpulsen ankommt.

Die Erfindung betrifft eine Schaltungsanordnung mit einem elektronischen, vorzugsweise berührungslos arbeitenden Schaltgerät und einem an den Ausgang des elektronischen Schaltgerätes angeschlossenen Fehlerindikator, wobei das elektronische Schaltgerät einen von außen beeinflußbaren Anwesenheitsindikator, z. B. einen Oszillator, und einen von dem Anwesenheitsindikator steuerbaren elektronischen Schalter, z. B. einen Transistor, einen Thyristor oder einen Triac, aufweist und mit Hilfe des Fehlerindikators feststellbar ist, ob das elektronische Schaltgerät und/oder ein an das elektronische Schaltgerät angeschlossener Außenleiter einen Fehler aufweist.

Elektronische Schaltgeräte der Art, wie sie wesentlicher Bestandteil der in Rede stehenden Schaltungsanordnung sind, sind kontaktlos ausgeführt und werden in zunehmendem Maße anstelle von elektrischen, mechanisch betätigten Schaltgeräten, die kontaktbehaftet ausgeführt sind, in elektrischen Meß-, Steuer- und Regelkreisen verwendet. Das gilt insbesondere für sogenannte Annäherungsschalter, d. h. für elektronische Schaltgeräte, die berührungslos arbeiten. Mit solchen Annäherungsschaltern wird indiziert, ob sich ein Beeinflussungselement, für das der entsprechende Annäherungsschalter sensitiv ist, dem Annäherungsschalter hinreichend weit genähert hat. (Hat sich nämlich ein Beeinflussungselement, für das der entsprechende Annäherungsschalter sensitiv ist, dem Anwesenheitsindikator hinreichend weit genähert, so steuert der Anwesenheitsindikator den elektronischen Schalter um; d. h. bei einem als Schließer ausgeführten Schaltgerät wird der nicht leitende elektronische Schalter nunmehr leitend, während bei einem als Öffner ausgeführten Schaltgerät der leitende elektronische Schalter nunmehr sperrt.)

Wesentlicher Bestandteil von elektronischen Schaltgeräten der zuvor beschriebenen Art ist also u. a. der von außen beeinflußbare Anwesenheitsindikator. Als Anwesenheitsindikator kann z. B. ein induktiv oder kapazitiv beeinflußbarer Oszillator vorgesehen sein; es handelt sich dann um induktive oder kapazitive Annäherungsschalter (vgl. z. B. die deutschen Offenlegungsschriften bzw. Auslegeschriften bzw. Patentschriften 19 51 137, 19 66 178, 19 66 213, 20 36 840, 21 27 956, 22 03 038, 22 03 039, 22 03 040, 22 03 906, 23 30 233, 23 31 732, 23 56 490, 26 13 423, 26 16 265, 26 16 733, 26 28 427, 27 11 877 und 27 44 785.) Als Anwesenheitsindikator kann z. B. ein Fotowiderstand, eine Fotodiode oder ein Fototransistor vorgesehen sein; es handelt sich dann um optoelektronische Annäherungsschalter (vgl. z. B. die deutsche Offenlegungsschrift 28 24 582).

Bei induktiven Annäherungsschaltern gilt für den Oszillator, solange ein Metallteil einen vorgegebenen Abstand noch nicht erreicht hat, $K \cdot V = 1$ mit K = Rückkopplungsfaktor und V = Verstärkungsfaktor des Oszillators, d. h. der Oszillator schwingt. Erreicht das entsprechende Metallteil den vorgeschriebenen Abstand, so führt die zunehmende Bedämpfung des Oszillators zu einer Verringerung des Verstärkungsfaktors V, so daß $K \cdot V < 1$ wird, d. h. der Oszillator hört auf zu schwingen. Bei kapazitiven Annäherungsschaltern gilt für den Oszillator, solange ein Ansprechkörper die Kapazität zwischen einer Ansprechelektrode und einer Gegenelektrode noch nicht hinreichend vergrößert hat, also einen vorgegebenen Abstand noch nicht erreicht hat, $K \cdot V < 1$, d. h. der Oszillator schwingt nicht. Erreicht der Ansprechkörper den vorgegebenen Abstand, so führt die steigende Kapazität zwischen der Ansprechelektrode und der Gegenelektrode zu einer Vergrößerung des Rückkopplungsfaktors K, so daß $K \cdot V = 1$ wird, d. h. der Oszillator beginnt zu schwingen. Bei beiden Ausführungsformen wird abhängig von den unterschiedlichen Zuständen des Oszillators der elektronische Schalter, z. B. ein Transistor, ein Thyristor oder ein Triac, gesteuert.

Optoelektronische Annäherungsschalter weisen einen Lichtsender und einen Lichtempfänger auf und werden auch als Lichtschranken bezeichnet. Dabei unterscheidet man zwischen einem Lichtschrankentyp, bei dem der Lichtsender und der Lichtempfänger auf entgegengesetzten Seiten einer Überwachungsstrecke angeordnet sind, und einem Lichtschrankentyp, bei dem der Lichtsender und der Lichtempfänger am gleichen Ende einer Überwachungsstrecke angeordnet sind, während ein am anderen Ende der Überwachungsstrecke angeordneter Reflektor den vom Lichtsender ausgehenden Lichtstrahl zum Lichtempfänger zurück reflektiert. In beiden Fällen spricht der Anwesenheitsindikator an, wenn der normalerweise vom Lichtsender zum Lichtempfänger gelangende Lichtstrahl durch ein in die Überwachungsstrecke gelangtes Beeinflussungselement unterbrochen wird. Es gibt jedoch auch Lichtschranken des zuletzt beschriebenen Lichtschrankentyps, bei dem der vom Lichtsender kommende Lichtstrahl nur durch ein entsprechendes Beeinflussungselement zum Lichtempfänger zurück reflektiert wird.

Elektronische, berührungslos arbeitende Schaltgeräte sind anfangs mit einer Reihe von Problemen behaftet gewesen, - gemessen an elektrischen, mechanisch betätigten Schaltgeräten, nämlich u. a. mit den Problemen "Erzeugung einer Speisespannung für den Oszillator", "Ausbildung des Oszillators", "Einschaltimpulsverhinderung", "Kurzschlußfestigkeit". Mit diesen Problemen und deren Lösungen (und mit anderen bei elektronischen, berührungslos arbeitenden Schaltgeräten relevanten Problemen und deren Lösungen) befassen sich z. B. die deutschen Offenlegungsschriften bzw. Auslegeschriften bzw. Patentschriften 19 51 137, 19 66 178, 19 66 213, 20 36 840, 21 27 956, 22 03 038, 22 03 039, 22 03 040, 22 03 906, 23 30 233, 23 31 732, 23 56 490, 26 13 423, 26 16 265, 26 16 773, 26 28 427, 27 11 877, 27 44 785, 29 43 911, 30 04 829, 30 38 102, 30 38 141 und 30 38 692.

Wie bereits ausgeführt, werden elektronische Schaltgeräte der in Rede stehenden Art in Meß-, Steuer- und Regelkreisen verwendet. Folglich hängt von der Funktionstüchtigkeit dieser Schaltgeräte häufig die Funktionstüchtigkeit der damit ausgerüsteten Meß-, Steuer- und Regelkreise - und damit die Funktionstüchtigkeit von Maschinen und Anlagen ab, zu denen solche Meß-, Steuer- und Regelkreise gehören.

Nun läßt sich nicht verhindern, daß an elektronischen Schaltgeräten der in Rede stehenden Art und an den an solche Schaltgeräte angeschlossenen Außenleitern Fehler auftreten. Um solche Fehler erkennen zu können, werden elektronische Schaltgeräte (und deren Außenleiter) "fehlerüberwacht", nämlich in Schaltungsanordnungen der eingangs beschriebenen Art, in denen also an den Ausgang des elektronischen Schaltgerätes ein Fehlerindikator angeschlossen ist und mit Hilfe des Fehlerindikators feststellbar ist, ob das elektronische Schaltgerät und/oder ein an das elektronische Schaltgerät angeschlossener Außenleiter einen Fehler aufweist.

Gesthuysen & von Rohr

— ϒ —

Bei einer bekannten Schaltungsanordnung der in Rede stehenden Art weist das elektronische Schaltgerät zwei antivalente Ausgänge auf und gibt der Fehlerindikator dann ein Fehlersignal ab, wenn am Fehlerindikator nicht ununterbrochen zwei antivalente Ausgangssignale ankommen. Dabei ist jedoch nicht ausgeschlossen, daß das elektronische Schaltgerät und/oder ein an das elektronische Schaltgerät angeschlossener Außenleiter einen Fehler aufweist und der Fehlerindikator gleichwohl kein Fehlersignal abgibt.

Der Erfindung liegt folglich die Aufgabe zugrunde, eine Schaltungsanordnung der in Rede stehenden Art anzugeben, bei der der Fehlerindikator mit an Sicherheit grenzender Wahrscheinlichkeit dann und nur dann ein Fehlersignal abgibt, wenn das elektronische Schaltgerät und/oder ein an das elektronische Schaltgerät angeschlossener Außenleiter einen Fehler aufweist.

Die erfindungsgemäße Schaltungsanordnung, bei der die zuvor aufgezeigte Aufgabe gelöst ist, ist zunächst und im wesentlichen dadurch gekennzeichnet, daß bei dem elektronischen Schaltgerät, wie an sich bekannt, zwischen dem Anwesenheitsindikator und dem Steuereingang des elektronischen Schalters ein exklusives ODER-Gatter geschaltet ist, wobei der erste Eingang des exklusiven ODER-Gatters an den Ausgang des Anwesenheitsindikators oder eines dem Anwesenheitsindikator nachgeschalteten Schaltverstärkers und der Ausgang des exklusiven ODER-Gatters an den Steuereingang des elektronischen Schalters angeschlossen sind, daß an den zweiten Eingang des exklusiven ODER-Gatters des elektronischen Schaltgerätes ein Überwachungsimpulse abgebender - externer oder interner - Überwachungsimpulsgenerator angeschlossen ist und daß der Fehlerindikator dann ein Fehlersignal abgibt, wenn am Fehlerindikator keine ununterbrochene Folge von Überwachungsimpulsen ankommt.

Erfindungsgemäß ist also eine "dynamische" Überwachung des elektronischen Schaltgerätes und der an das elektronische Schaltgerät angeschlossenen Außenleiter verwirklicht. Die Überwachungsimpulse, dem elektronischen Schaltgerät von außen zugeführt oder innerhalb des elektronischen Schaltgerätes erzeugt, gelangen nur dann in ununterbrochener Folge zu dem Fehlerindikator,

Gesthuysen & von Rohr

-5-

wenn das elektronische Schaltgerät und die an das elektronische Schaltgerät angeschlossenen Außenleiter fehlerfrei sind. Dadurch, daß erfindungsgemäß bei dem elektronischen Schaltgerät zwischen dem Anwesenheitsindikator und dem Steuereingang des elektronischen Schalters ein exklusives ODER-Gatter geschaltet ist und an den zweiten Eingang des exklusiven ODER-Gatters fortlaufend Überwachungsimpulse gegeben werden, sind die Teile des elektronischen Schaltgerätes, die besonders fehlergefährdet sind, insbesondere auch der elektronische Schalter des elektronischen Schaltgerätes, und die an das elektronische Schaltgerät angeschlossenen Außenleiter in die Fehlerüberwachung einbezogen.

(Aus der DE-PS 26 28 427, deren Offenbarungsgehalt hiermit ausdrücklich auch hier zur Offenbarung gemacht wird, ist es an sich bekannt, bei einem elektronischen Schaltgerät, bestehend aus einem von außen beeinflußbaren Oszillator und einem von dem Oszillator steuerbaren Thyristor, zwischen dem Oszillator und der Zündelektrode des Thyristors ein exklusives ODER-Gatter zu schalten, derart, daß der erste Eingang des exklusiven ODER-Gatters an den Ausgang des Oszillators oder eines dem Oszillator nachgeschalteten Schaltverstärkers angeschlossen, der zweite Eingang des exklusiven ODER-Gatters mit einem Umkehrsteuersignal beaufschlagbar und der Ausgang des exklusiven ODER-Gatters an die Zündelektrode des Thyristors angeschlossen ist. Dabei ist die Aufgabe gelöst, ein elektronisches Schaltgerät der in Rede stehenden Art anzugeben, das sowohl als Öffner als auch als Schließer benutzt und durch eine einfache Maßnahme am fertigen Schaltgerät zu einem Öffner bzw. zu einem Schließer gemacht werden kann.)

Der wesentliche Gedanke der vorliegenden Erfindung, eine "dynamische" Überwachung eines elektronischen Schaltgerätes und der an das elektronische Schaltgerät angeschlossenen Außenleiter unter Einbezug der Teile des elektronischen Schaltgerätes, die besonders fehlergefährdet sind, kann selbstverständlich auch anders als dadurch verwirklicht werden, daß bei dem elektronischen Schaltgerät zwischen dem Anwesenheitsindikator und dem Steuereingang des elektronischen Schalters ein exklusives ODER-Gatter geschaltet ist. Insbesondere kann eine ununterbrochene Folge von Überwachungsimpulsen auch in den Anwesenheitsindikator eingespeist und damit auch noch die Funktionstüchtigkeit des Anwesenheitsindikators überwacht werden.

Im einzelnen gibt es verschiedene Möglichkeiten, die erfindungsgemäße Schaltungsanordnung auszugestalten und weiterzubilden, was im folgenden nur beispielhaft erläutert werden soll.

Wenn bei der erfindungsgemäßen Schaltungsanordnung am Fehlerindikator keine
ununterbrochene Folge von Überwachungsimpulsen ankommt, dann muß der Fehlerindikator ein Fehlersignal abgeben. Dazu empfiehlt es sich, den Fehlerindikator mit einem Überwachungsimpulsintegrator zu versehen, der aus den Überwachungsimpulsen einen Mittelwert bildet, so daß beim Ausbleiben von Überwachungsimpulsen der Mittelwert Null wird und daraus dann das Fehlersignal
abgeleitet wird.

Bei der erfindungsgemäßen Schaltungsanordnung führt das bei dem elektronischen Schaltgerät zwischen dem Anwesenheitsindikator und dem Steuereingang des elektronischen Schalters geschaltete exklusive ODER-Gatter, dessen
zweiter Eingang mit Überwachungsimpulsen beaufschlagt wird, zunächst dazu,
daß sich das Ausgangssignal des elektronischen Schaltgerätes im Rhythmus der
Überwachungsimpulse ändert. Das kann dadurch eliminiert werden, daß an den
Ausgang des elektronischen Schaltgerätes ein Ausgangssignalintegrator angeschlossen wird, der aus dem "getakteten" Ausgangssignal des elektronischen
Schaltgerätes einen Mittelwert bildet und dessen Ausgang den "verwertbaren"
Ausgang der erfindungsgemäßen Schaltungsanordnung darstellt. Von besonderer
Bedeutung ist jedoch eine bevorzugte Ausführungsform der erfindungsgemäßen
Schaltungsanordnung, die dadurch gekennzeichnet ist, daß dem Ausgang des
elektronischen Schaltgerätes ein weiteres exklusives ODER-Gatter nachgeschaltet ist, wobei der erste Eingang des weiteren exklusiven ODER-Gatters
an den Ausgang des elektronischen Schaltgerätes und der zweite Eingang des
weiteren exklusiven ODER-Gatters an den Überwachungsimpulsgenerator angeschlossen sind und der Ausgang des weiteren exklusiven ODER-Gatters den
"verwertbaren" Ausgang der Schaltungsanordnung darstellt. Bei dieser Ausführungsform wird also die Beeinflussung des Ausgangssignals des elektronischen Schaltgerätes durch das zwischen dem Anwesenheitsindikator und dem Steuereingang des elektronischen Schalters geschaltete ODER-Gatter, dessen zweiter Eingang mit Überwachungsimpulsen beaufschlagt ist, durch ein zweites ODER-Gatter, dessen zweiter Eingang mit den gleichen Überwachungsimpulsen beaufschlagt ist, eliminiert.

Bei der zuletzt beschriebenen Ausführungsform der erfindungsgemäßen Schaltungsanordnung kann die "Laufzeit" der Überwachungsimpulse vom Überwachungsimpulsgenerator zum Ausgang des elektronischen Schaltgerätes und damit zum ersten Eingang des zweiten exklusiven ODER-Gatters wesentlich länger sein als die "Laufzeit" der Überwachungsimpulse vom Überwachungsimpulsgenerator zum zweiten Eingang des zweiten exklusiven ODER-Gatters. Dann empfiehlt es sich, zwischen dem Überwachungsimpulsgenerator und dem zweiten Eingang des weiteren exklusiven ODER-Gatters ein Verzögerungsglied zu schalten.

Schließlich geht eine weitere Lehre der Erfindung mit besonderer Bedeutung dahin, dem elektronischen Schaltgerät und dem Fehlerindikator einen Sicherheitsschaltkreis mit zwei Eingängen und einem Ausgang nachzuschalten und den ersten Eingang des Sicherheitsschaltkreises an den Ausgang des elektronischen Schaltgerätes, an den Ausgang des Ausgangssignalindikators oder an den Ausgang des weiteren exklusiven ODER-Gatters und den zweiten Eingang des Sicherheitsschaltkreises an den Ausgang des Fehlerindikators anzuschliessen und am Ausgang des Sicherheitsschaltkreises ein bestimmtes Ausgangssignal dann und nur dann anstehen zu lassen, wenn dieses Ausgangssignal das Ausgangssignal des elektronischen Schaltgerätes ist und der Fehlerindikator ein Fehlersignal nicht abgibt. Bei dieser sicherheitstechnisch besonders bedeutungsvollen Ausführungsform der erfindungsgemäßen Schaltungsanordnung wird also dafür gesorgt, daß z. B. das Ausgangssignal des elektronischen Schaltgerätes "Elektronischer Schalter leitend" nur dann - am "verwertbaren" Ausgang der Schaltungsanordnung - ansteht, wenn dieses Ausgangssignal das Ausgangssignal des elektronischen Schaltgerätes ist und der Fehlerindikator ein Fehlersignal nicht abgibt; gibt der Fehlerindikator ein Fehlersignal ab, so steht am "verwertbaren" Ausgang der Schaltungsanordnung - statt des am Ausgang des elektronischen Schaltgerätes anstehenden Ausgangssignals "Elektronischer Schalter leitend" - das Ausgangssignal "Elektronischer Schalter
nicht leitend" an.

Zuvor ist bereits ausgeführt worden, daß der wesentliche Gedanke der Erfindung, eine "dynamische" Überwachung eines elektronischen Schaltgerätes
und der an das elektronische Schaltgerät angeschlossenen Außenleiter unter Einbezug der Teile des elektronischen Schaltgerätes, die besonders
fehlergefährdet sind, auch anders als dadurch verwirklicht werden kann,
daß bei dem elektronischen Schaltgerät zwischen dem Anwesenheitsindikator
und dem Steuereingang des elektronischen Schalters ein exklusives ODER-
Gatter geschaltet ist, daß nämlich auch eine ununterbrochene Folge von
Überwachungsimpulsen in den Anwesenheitsindikator eingespeist und damit
auch noch die Funktionstüchtigkeit des Anwesenheitsindikators überwacht
werden kann. Das Einspeisen einer ununterbrochenen Folge von Überwachungsimpulsen in den Anwesenheitsindikator ist jedoch mit einem nicht unerheblichen Aufwand verbunden. Deshalb geht eine weitere Lehre der Erfindung
dahin, der wiederum besondere Bedeutung zukommt, zwischen dem Überwachungsimpulsgenerator und dem zweiten Eingang des exklusiven ODER-
Gatters und/oder zwischen dem Überwachungsimpulsgenerator und dem zweiten
Eingang des weiteren exklusiven ODER-Gatters eine Überwachungsleitung vorzusehen und die Überwachungsleitung mindestens einseitig über und/oder um
den Anwesenheitsindikator zu führen. Handelt es sich bei der erfindungsgemäßen Schaltungsanordnung um eine solche, bei der der Anwesenheitsindikator des elektronischen Schaltgerätes als Oszillator ausgeführt ist und
eine Oszillatorspule aufweist, dann empfiehlt es sich, die Überwachungsleitung über und/oder um die Oszillatorspule zu führen, insbesondere über
die nach außen gerichtete Stirnfläche der Oszillatorspule zu führen.

Bei der zuletzt beschriebenen Ausführungsform der erfindungsgemäßen Schaltungsanordnung, also der mit einer Überwachungsleitung, ist berücksichtigt worden, daß der Anwesenheitsindikator besonders mechanischen Beanspruchungen ausgesetzt sein kann. Dadurch, daß die in Rede stehende Überwachungsleitung über und/oder um den Anwesenheitsindikator geführt ist,
führt eine mechanische Beschädigung des Anwesenheitsindikators, z. B. der Oszillatorspule eines als Oszillator ausgeführten Anwesenheitsindikators, auch zu einer Beschädigung der Überwachungsleitung, - mit der Folge, daß dann am Fehlerindikator keine ununterbrochene Folge von Überwachungsimpulsen ankommen kann, der Fehlerindikator also ein Fehlersignal abgibt.

Im folgenden wird die Erfindung anhand einer lediglich ein Ausführungsbeispiel darstellenden Zeichnung nochmals erläutert; es zeigt

Fig. 1       das Blockschaltbild einer bevorzugten Ausführungsform einer erfindungsgemäßen Schaltungsanordnung und

Fig. 2       schematisch, den "Kopf" eines zu der bevorzugten Ausführungsform der erfindungsgemäßen Schaltungsanordnung nach Fig. 1 gehörenden Schaltgerätes.

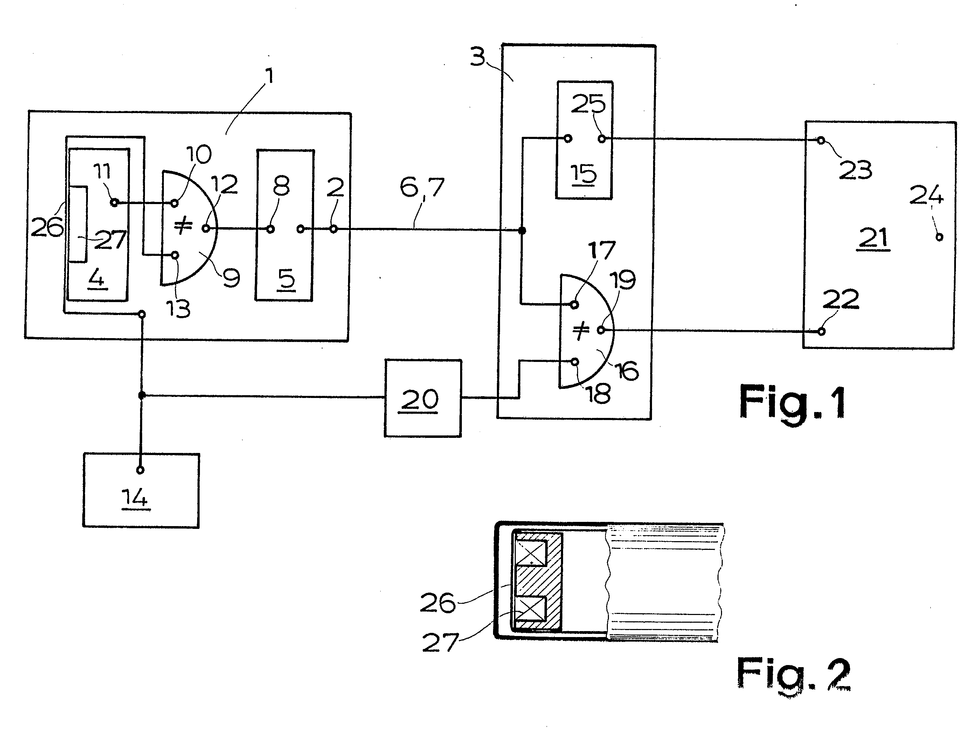

Die Fig. 1 zeigt - in Form eines Blockschaltbildes - eine Schaltungsanordnung mit einem elektronischen, berührungslos arbeitenden Schaltgerät 1 und einem an den Ausgang 2 des elektronischen Schaltgerätes 1 angeschlossenen Fehlerindikator 3. Das elektronische Schaltgerät 1 weist einen von außen beeinflußbaren Anwesenheitsindikator 4, nämlich einen Oszillator, und einen von dem Anwesenheitsindikator 4 steuerbaren elektronischen Schalter 5, z. B. einen Transistor, auf. Mit Hilfe des Fehlerindikators 3 ist feststellbar, ob das elektronische Schaltgerät 1 und/oder ein an das elektronische Schaltgerät 1 angeschlossener Außenleiter 6, 7 einen Fehler aufweist.

Bei dem elektronischen Schaltgerät 1 ist zwischen dem Anwesenheitsindikator 4 und dem Steuereingang 8 des elektronischen Schalters 5 ein exklusives ODER-Gatter 9 geschaltet, wobei der erste Eingang 10 des exklusiven ODER-Gatters 9 an den Ausgang 11 des Anwesenheitsindikators 4 und der Ausgang 12 des exklusiven ODER-Gatters 9 an den Steuereingang 8 des elektronischen Schalters 5 angeschlossen sind. An den zweiten Eingang 13 des exklusiven ODER-Gatters 9 ist ein Überwachungsimpulse abgebender externer Überwachungsimpulsgenerator 14 angeschlossen. Der Fehlerindikator 3 gibt dann ein Fehlersignal ab, wenn am Fehlerindikator 3 keine ununterbrochene Folge von Überwachungsimpulsen ankommt.

Im dargestellten Ausführungsbeispiel weist der Fehlerindikator 3 einen
Überwachungsimpulsintegrator 15 auf und ist dem Ausgang 2 des elektronischen Schaltgerätes 1 ein weiteres exklusives ODER-Gatter 16 nachgeschaltet, wobei der erste Eingang 17 des weiteren exklusiven ODER-Gatters 16 an den Ausgang 2 des elektronischen Schaltgerätes 1 und der
zweite Eingang 18 des weiteren exklusiven ODER-Gatters 16 an den Überwachungsimpulsgenerator 14 angeschlossen sind und der Ausgang 19 des weiteren exklusiven ODER-Gatters 16 den "verwertbaren" Ausgang der erfindungsgemäßen Schaltungsanordnung darstellen kann.

Wie die Fig. 1 zeigt, ist zwischen dem Überwachungsimpulsgenerator 14
und dem zweiten Eingang 18 des weiteren exklusiven ODER-Gatters 16 ein
Verzögerungsglied 20 geschaltet.

Im übrigen zeigt die Fig. 1 insoweit eine bevorzugte Ausführungsform der
erfindungsgemäßen Schaltungsanordnung, als dem elektronischen Schaltgerät 1 und dem Fehlerindikator 3 ein Sicherheitsschaltkreis 21 mit zwei
Eingängen 22, 23 und einem Ausgang 24 nachgeschaltet ist, wobei der erste
Eingang 22 des Sicherheitsschaltkreises 21 an den Ausgang 19 des weiteren
exklusiven ODER-Gatters 16 und der zweite Eingang 23 des Sicherheitsschaltkreises 21 an den Ausgang 25 des Fehlerindikators 3 angeschlossen sind und
am Ausgang 24 des Sicherheitsschaltkreises 21 ein bestimmtes Ausgangssignal dann und nur dann ansteht, wenn dieses Ausgangssignal das Ausgangssignal des elektronischen Schaltgerätes 1 ist und der Fehlerindikator 3 ein
Fehlersignal nicht abgibt.

Schließlich zeigen die Figuren auch insoweit eine bevorzugte Ausführungsform der erfindungsgemäßen Schaltungsanordnung, als zwischen dem Überwachungsimpulsgenerator 14 und dem zweiten Eingang 13 des exklusiven
ODER-Gatters 9 eine Überwachungsleitung 26 vorgesehen und die Überwachungsleitung 26 über den Anwesenheitsindikator 4 geführt ist. Bei dem dargestellten Ausführungsbeispiel der erfindungsgemäßen Schaltungsanordnung
handelt es sich um ein solches, bei der der Anwesenheitsindikator 4 des
elektronischen Schaltgerätes 1 als Oszillator ausgeführt ist und eine Oszillatorspule 27 aufweist. Im einzelnen ist deshalb die Überwachungsleitung 26 über die Oszillatorspule 27 geführt, und zwar über die nach außen gerichtete Stirnfläche der Oszillatorspule 27.

Gesthuysen & von Rohr

Patentansprüche:

1. Schaltungsanordnung mit einem elektronischen, vorzugsweise berührungslos
arbeitenden Schaltgerät und einem an den Ausgang des elektronischen Schaltgerätes angeschlossenen Fehlerindikator, wobei das elektronische Schaltgerät einen von außen beeinflußbaren Anwesenheitsindikator, z. B. einen Oszillator, und einen von dem Anwesenheitsindikator steuerbaren elektronischen
Schalter, z. B. einen Transistor, einen Thyristor oder einen Triac, aufweist und mit Hilfe des Fehlerindikators feststellbar ist, ob das elektronische Schaltgerät und/oder ein an das elektronische Schaltgerät angeschlossener Außenleiter einen Fehler aufweist, d a d u r c h  g e k e n n -
z e i c h n e t, daß bei dem elektronischen Schaltgerät (1), wie an sich bekannt, zwischen dem Anwesenheitsindikator (4) und dem Steuereingang (8) des
elektronischen Schalters (5) ein exklusives ODER-Gatter (9) geschaltet ist,
wobei der erste Eingang (10) des exklusiven ODER-Gatters (9) an den Ausgang (11) des Anwesenheitsindikators (4) oder eines dem Anwesenheitsindikator nachgeschalteten Schaltverstärkers und der Ausgang (12) des exklusiven
ODER-Gatters (9) an den Steuereingang (8) des elektronischen Schalters (5)
angeschlossen sind, daß an den zweiten Eingang (13) des exklusiven ODER-
Gatters (9) des elektronischen Schaltgerätes (1) ein Überwachungsimpulse
abgebender Überwachungsimpulsgenerator (14) angeschlossen ist und daß der
Fehlerindikator (3) dann ein Fehlersignal abgibt, wenn am Fehlerindikator (3) keine ununterbrochene Folge von Überwachungsimpulsen ankommt.

2. Schaltungsanordnung nach Anspruch 1, dadurch gekennzeichnet, daß der
Fehlerindikator (3) einen Überwachungsimpulsintegrator (15) aufweist.

3. Schaltungsanordnung nach Anspruch 1 oder 2, dadurch gekennzeichnet, daß
an den Ausgang des elektronischen Schaltgerätes ein Ausgangssignalintegrator angeschlossen ist und der Ausgang des Ausgangssignalintegrators den
"verwertbaren" Ausgang der Schaltungsanordnung darstellt.

- 1 -

Gesthuysen & von Rohr

4. Schaltungsanordnung nach Anspruch 1 oder 2, dadurch gekennzeichnet, daß dem Ausgang (2) des elektronischen Schaltgerätes (1) ein weiteres exklusives ODER-Gatter (16) nachgeschaltet ist, wobei der erste Eingang (17) des weiteren exklusiven ODER-Gatters (16) an den Ausgang (2) des elektronischen Schaltgerätes (1) und der zweite Eingang (18) des weiteren exklusiven ODER-Gatters (16) an den Überwachungsimpulsgenerator (14) angeschlossen sind und der Ausgang (19) des weiteren exklusiven ODER-Gatters (16) den "verwertbaren" Ausgang der Schaltungsanordnung darstellt.

5. Schaltungsanordnung nach Anspruch 4, dadurch gekennzeichnet, daß zwischen dem Überwachungsimpulsgenerator (14) und dem zweiten Eingang (18) des weiteren exklusiven ODER-Gatters (16) ein Verzögerungsglied (20) geschaltet ist.

6. Schaltungsanordnung nach einem der Ansprüche 1 bis 5, dadurch gekennzeichnet, daß dem elektronischen Schaltgerät (1) und dem Fehlerindikator (3) ein Sicherheitsschaltkreis (21) mit zwei Eingängen (22, 23) und einem Ausgang (24) nachgeschaltet ist, wobei der erste Eingang (22) des Sicherheitsschaltkreises (21) an den Ausgang des elektronischen Schaltgerätes, an den Ausgang des Ausgangssignalindikators oder an den Ausgang (19) des weiteren exklusiven ODER-Gatters (16) und der zweite Eingang (23) des Sicherheitsschaltkreises (21) an den Ausgang (25) des Fehlerindikators (3) angeschlossen sind und am Ausgang (24) des Sicherheitsschaltkreises (21) ein bestimmtes Ausgangssignal dann und nur dann ansteht, wenn dieses Ausgangssignal das Ausgangssignal des elektronischen Schaltgerätes (1) ist und der Fehlerindikator (3) ein Fehlersignal nicht abgibt.

7. Schaltungsanordnung nach einem der Ansprüche 1 bis 6, dadurch gekennzeichnet, daß zwischen dem Überwachungsimpulsgenerator (14) und dem zweiten Eingang (13) des exklusiven ODER-Gatters (9) und/oder zwischen dem Überwachungsimpulsgenerator (14) und dem zweiten Eingang (18) des weiteren exklusiven ODER-Gatters (16) eine Überwachungsleitung (26) vorgesehen und die Überwachungsleitung (26) mindestens einseitig über und/oder um den Anwesenheitsindikator (4) geführt ist.

- 2 -

8. Schaltungsanordnung nach Anspruch 7, bei der der Anwesenheitsindikator des elektronischen Schaltgerätes als Oszillator ausgeführt ist und eine Oszillatorspule aufweist, dadurch gekennzeichnet, daß die Überwachungsleitung (26) über und/oder um die Oszillatorspule (27) geführt ist.

9. Schaltungsanordnung nach Anspruch 8, dadurch gekennzeichnet, daß die Überwachungsleitung (26) über die nach außen gerichtete Stirnfläche der Oszillatorspule (27) geführt ist.

- 3 -

Fig. 1

Fig. 2

0075086